# EUROPEAN PATENT APPLICATION

(11) **EP 4 654 383 A1**
(43) Date of publication of application: **26.11.2025**
(21) Application number: 24823548.3
(22) Date of filing: 17.04.2024
(51) Int. Cl.: H01Q 9/04, H03H 7/38, H01Q 1/24, H01Q 1/38, G01R 31/382, H04M 1/02

(54) **ELECTRONIC DEVICE AND METHOD FOR CONNECTING PASSIVE ELEMENT TO ANTENNA USING SAME**

(30) Priority: 15.06.2023 KR 20230076901; 20.07.2023 KR 20230094482
(71) Applicant: Samsung Electronics Co., Ltd., Suwon-si, Gyeonggi-do 16677 (KR)
(72) Inventor: KIM, Hansol, Suwon-si, Gyeonggi-do 16677 (KR); NOH, Hyungbin, Suwon-si, Gyeonggi-do 16677 (KR); YUN, Heeyoung, Suwon-si, Gyeonggi-do 16677 (KR); LEE, Jooho, Suwon-si, Gyeonggi-do 16677 (KR)
(74) Representative: Gulde & Partner
(86) International application number: PCT/KR2024/005154
(87) International publication number: WO 2024/258027

(57) **Abstract**

According to an embodiment, an electronic device may include: a battery, a retaining member comprising a support disposed on one surface of the battery and configured to function as an antenna corresponding to a first frequency band, and a printed circuit board disposed on an other surface of the battery, the printed circuit board including a communication circuit electrically connected to the retaining member. The electronic device may include a switch configured to electrically connect at least one passive element among multiple passive elements and the retaining member, a memory, and at least one processor, comprising processing circuitry, operatively connected to the communication circuit, the switch, and the memory. According to an embodiment, at least one processor, individually and/or collectively, may be configured to: identify a remaining capacity of the battery; identify information regarding a passive element to be connected to the retaining member, based on the identified remaining capacity of the battery and the first frequency band; select at least one passive element among the multiple passive elements, based on the identified information regarding a passive element; and control the switch such that the at least one selected passive element and the retaining member are electrically connected.

## Description

### [Technical Field]

The disclosure relates to an electronic device and a method for connecting a passive element to an antenna using the same.

### [Background Art]

In line with recent technological developments, electronic devices have evolved from unilaterally rectangular shapes to more diversified shapes. For example, electronic devices are gradually evolving toward wearable electronic devices which can be worn on a part of the user's body such that users can use them more conveniently. Wearable electronic devices include antennas (for example, antenna radiators) corresponding to various frequency bands. For example, wearable electronic devices may include multiple antennas for performing wireless communication such as long-term evolution (LTE) and wireless fidelity (Wi-Fi) and short-range communication such as Bluetooth.

Electronic devices (for example, wearable electronic devices) have restrictions on their size and weight because there are at least partially worn on the user's body, and this may further restrict the internal space in which various parts example, components) are to be mounted. At least a part of a metal frame (for example, a plate or a stainless (SUS) plate) of the housing of an electronic device may be used as an antenna radiator. For example, at least a part of a metal member (for example, a retaining member, a plate, steel type stainless (STS), steel use stainless (SUS), stainless steel, or a bracket) included in the housing may be used as an antenna radiator.

The above-described information may be provided as a related art intended to aid in understanding of the disclosure. No claim or decision is made regarding whether any of the above descriptions can be applied as a prior art related to the disclosure.

### [Disclosure of Invention]

### [Technical Problem]

Electronic devices (for example, wearable devices or wearable watches) may have multiple components disposed in the narrow internal space thereof. The ground condition regarding respective components mounted in the internal space of electronic devices, or electrical characteristics thereof may be substantially changed by changes in communication environments. Particularly, the antenna efficiency in a relatively low frequency band (for example, about 600Mhz to about 900Mhz) is heavily influenced by the remaining capacity of the battery disposed between the radiator (for example, the SUS of the battery) and the printed circuit board (PCB) (for example, the remaining battery capacity among the entire battery capacity). For example, the battery thickness may be changed by the remaining battery capacity, and a change in the battery thickness may cause a problem in that the communication performance based on the radiator and the printed circuit board may deteriorate. The electronic device may have a problem in that, depending on the remaining battery capacity, the communication performance in a configured first frequency band (for example, a relatively low frequency band, about 600Mhz to about 900Mhz) may deteriorate.

Embodiments of the disclosure provide an electronic device wherein, in a state in which the retaining member (for example, SUS structure) that functions as an antenna radiator and the printed circuit board are electrically connected, the communication circuit included in the printed circuit board may include a switch module (for example, an RF switch) and at least one passive element. Embodiments of the disclosure provide an electronic device that may control the switch module (for example, an RF switch) such that, according to the remaining battery capacity (for example, the amount of remaining charge), at least one passive element is connected to an antenna radiator corresponding to a first frequency band, and may be configured such that a passive element value corresponding to the connected passive element is applied to the antenna radiator.

Embodiments of the disclosure may provide an electronic device configured to control a switch module (for example, an RF switch) such that at least one passive element is connected to an antenna radiator, based on remaining battery capacity information and a first frequency band.

Technical problems to be solved by the disclosure are not limited to the above-mentioned technical problems, and other technical problems not mentioned herein will be clearly understood from the following description by those skilled in the art to which the disclosure pertains.

### [Solution to Problem]

According to an example embodiment, an electronic device may include: a battery, a retaining member comprising a support disposed on one surface of the battery and configured to function as an antenna corresponding to a first frequency band, and a printed circuit board disposed on an other surface of the battery, the printed circuit board including a communication circuit electrically connected to the retaining member, wherein the electronic device may include: a switch configured to electrically connect at least one passive element among multiple passive elements and the retaining member, a memory, and at least one processor, comprising processing circuitry, operatively connected to the communication circuit, the switch, and the memory. According to an example embodiment, at least one processor, individually and/or collectively, may be configured to identify the remaining capacity of the battery; identify information regarding a passive element to be connected to the retaining member, based on the identified remaining capacity of the battery and the first frequency band; select at least one passive element among the multiple passive elements, based on the identified information regarding a passive element; control the switch such that the at least one selected passive element and the retaining member are electrically connected; and apply a passive element value based on the at least one passive element to the retaining member.

According to an example embodiment, a method for connecting a passive element to an antenna may include: identifying the remaining capacity of a battery disposed between a retaining member comprising a support configured to function as an antenna corresponding to a first frequency band and a printed circuit board including a communication circuit electrically connected to the retaining member, identifying information regarding a passive element to be connected to the retaining member, based on the identified remaining capacity of the battery and the first frequency band, selecting at least one passive element among multiple passive elements, based on the identified information regarding a passive element, and controlling the switch such that the at least one selected passive element and the retaining member are electrically connected.

According to an example embodiment, a non-transitory computer-readable storage medium (or computer program product) in which one or more programs for executing a method for connecting a passive element to an antenna of an electronic device are stored, may be disclosed. According to an embodiment, the one or more programs may include instructions which, when executed by at least one processor, comprising processing circuitry, individually and/or collectively, of the electronic device, cause the electronic device to perform operations comprising: identifying a remaining capacity of a battery disposed between a retaining member configured to function as an antenna corresponding to a first frequency band and a printed circuit board including a communication circuit electrically connected to the retaining member, identifying information regarding a passive element to be connected to the retaining member, based on the identified remaining capacity of the battery and the first frequency band, selecting at least one passive element among multiple passive elements, based on the identified information regarding a passive element; and controlling a switch such that the at least one selected passive element and the retaining member are electrically connected.

### [Advantageous Effects of Invention]

According to various example embodiments, the electronic device may identify the remaining capacity of the battery, and may select at least one passive element to be connected to a first antenna radiator corresponding to a first frequency band (for example, about 600MHz to about 900Mhz) according to the remaining capacity of the battery. For example, the at least one passive element may apply a passive element value to the first antenna radiator. The electronic device may select at least one passive element such that the passive element value corresponding to the configured passive element is applied to the first antenna radiator corresponding to the first frequency band.

According to various example embodiments, the electronic device may apply a passive element value corresponding to at least one passive element to the first antenna radiator, based on the at least one selected passive element, thereby maintaining optimal communication performance in the first frequency band. According to various example embodiments, the electronic device may select at least one passive element to be connected to the first antenna radiator such that optimal communication performance can be maintained in the communication frequency band without being affected by the remaining capacity of the battery. The communication efficiency in the first frequency band may be enhanced. According to various example embodiments, the electronic device may provide the user with optimal communication performance.

Advantageous effects obtainable from the disclosure are not limited to the above-mentioned advantageous effects, and other advantageous effects not mentioned herein will be clearly understood from the following description by those skilled in the art to which the disclosure pertains.

### BRIEF DESCRIPTION OF THE DRAWINGS

In relation to the description of the drawings, identical or similar components may be given identical or similar reference numerals. Further, the above and other aspects, features and advantages of certain embodiments of the present disclosure will be more apparent from the following detailed description, taken in conjunction with the accompanying drawings, in which:
FIG. 1 is a block diagram illustrating an example electronic device in a network environment according to various embodiments;
FIG. 2 is a front perspective view of an electronic device according to various embodiments;
FIG. 3 is a rear perspective view of an electronic device according to various embodiments;
FIG. 4 is an exploded perspective view of an electronic device according to various embodiments;
FIG. 5 is a cross-sectional view of an electronic device according to various embodiments;
FIG. 6 is a block diagram illustrating an example configuration of an electronic device according to various embodiments;
FIG. 7 is a flowchart illustrating an example method for connecting a passive element to an antenna radiator of an electronic device according to various embodiments;
FIG. 8 is a circuit diagram illustrating an example switch module configured to electrically connect an antenna radiator and a passive element according to various embodiments; and
FIG. 9 is a graph illustrating a change in radiation efficiency according to connection of a passive element according to various embodiments.

### DETAILED DESCRIPTION

Hereinafter, various example embodiments of the disclosure will be described in greater detail with reference to the accompanying drawings. However, the disclosure may be implemented in various different forms without being limited to the various example embodiments described herein. In relation to the description of the drawings, identical or similar components may be given identical or similar reference numerals. In addition, in the drawings and related descriptions, descriptions of known functions and configurations may be omitted for clarity and brevity of description.

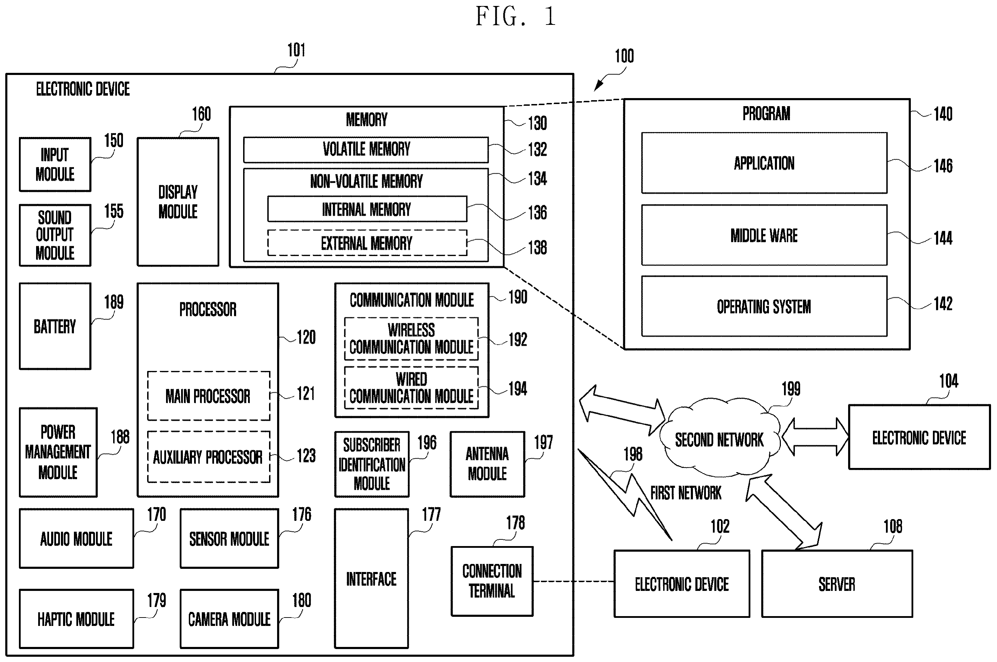

FIG. 1 is a block diagram illustrating an example electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of lms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band. For example, the plurality of antennas may include a patch array antenna and/or a dipole array antenna.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

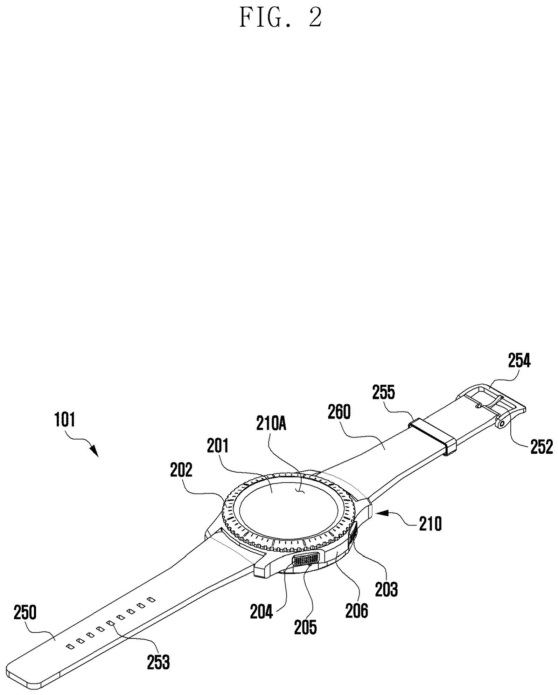

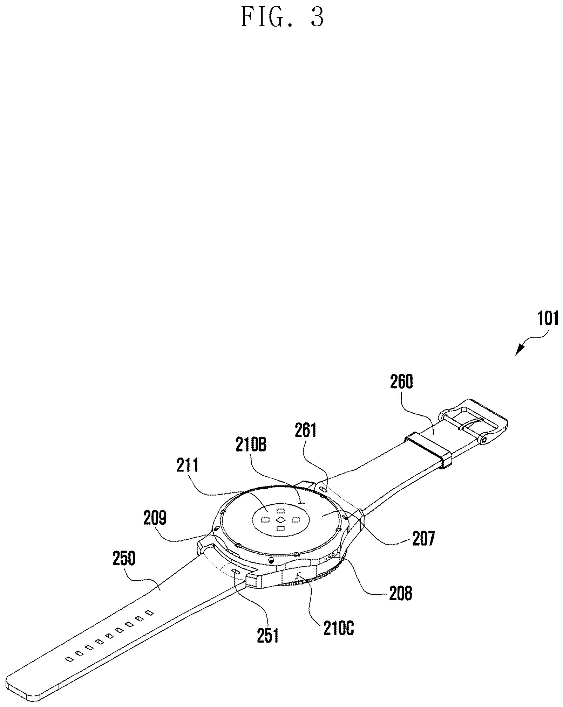

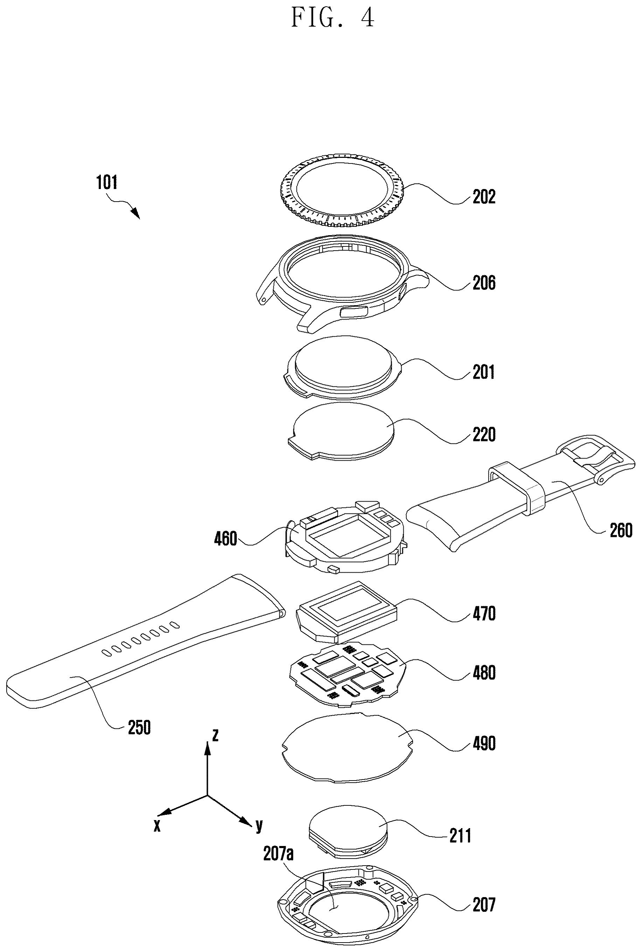

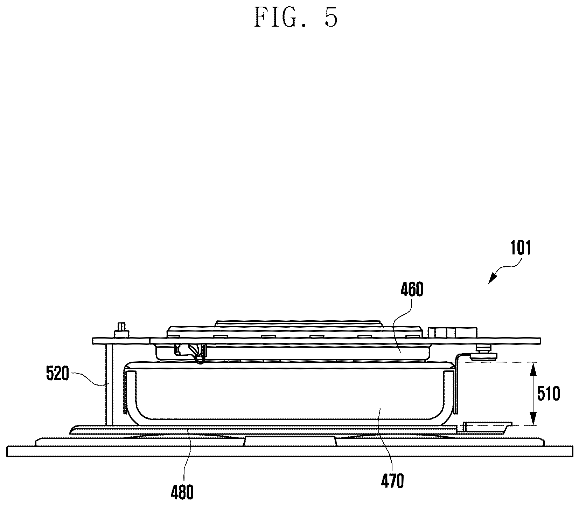

FIG. 2 is a front perspective view of an electronic device according to various embodiments. FIG. 3 is a rear perspective view of an electronic device according to various embodiments. FIG. 4 is an exploded perspective view of an electronic device according to various embodiments. FIG. 5 is a cross-sectional view of an electronic device according to various embodiments.

The electronic device 101 in FIG. 2 to FIG. 5 (for example, the electronic device 101 in FIG. 1) may be at least partially similar to the electronic device 101 in FIG. 1, or may further include other configurations of the electronic device. For example, the electronic device 101 may include a wearable electronic device which can be worn on a part of a human body.

Referring to FIG. 2 and FIG. 3, the electronic device 101 according to an embodiment (for example, a wearable electronic device or a wearable watch) may include a housing 210 including a first surface (or front surface) 210A, a second surface (or rear surface) 210B, and a lateral surface 210C surrounding the space between the first surface 210A and the second surface 210B, and clamping members 250 and 260 connected to at least a part of the housing 210 and configured such that the electronic device 101 can be detachably clamped to a part of the user's body (for example, wrist or ankle). The clamping members 250 and 260 may be straps, for example, wound around the user's wrist such that the electronic device 101 is retained. In an embodiment (not illustrated), the housing may refer to a structure forming at least some of the first surface 210A, the second surface 210B, and the lateral sur5face 210C of the electronic device 101. According to an embodiment, at least a part of the first surface 210A may be formed by a substantially transparent front plate 201 (for example, a glass plate including various coating layers, or a polymer plate). The second surface 210B may be formed by a rear plate 207. The rear plate 207 may be formed by, for example, coated or colored glass, ceramic, polymer, metal (for example, aluminum, stainless steel (STS), or magnesium), or a combination of at least two of the above materials. The lateral surface 210C may be coupled to the front plate 201 and the rear plate 207, and may be formed by a lateral bezel structure (or (lateral member") 206 including a metal and/or a polymer. In various embodiments, the rear plate 207 and the lateral bezel structure 206 may be formed integrally, and may include the same material (for example, a metal material such as aluminum). The clamping members 250 and 260 may be made of various materials in various shapes. For example, integrated and multiple unit links may be formed to be movable with regard to each other using, for example, a woven material, leather, rubber, synthetic resin, metal, ceramic, or a combination of at least two of the above materials.

According to an embodiment, the electronic device 101 may include at least one of a display (for example, the display module 160 in FIG. 1 and/or the display 220 in FIG. 4), audio modules 205 and 208 (for example, the audio module 170 in FIG. 1), a sensor module 211 (for example, the sensor module 176 in FIG. 1), key input devices 202, 203, and 204 (for example, the input module 150 in FIG. 1), and a connector hole 209 (for example, the connection terminal 176 in FIG. 1). In various embodiments, at least one of the components (for example, the key input devices 202, 203, and 204, the connector hole 209, or the sensor module 211) of the electronic device 101 may be omitted, or the electronic device 101 may additionally include other components. According to an embodiment, the components are not limited to the parts illustrated in FIG. 2 to FIG. 5.

The display 220 may be visible, for example, through a corresponding portion of the front plate 201. For example, the user may identify at least one content displayed on the display 220 through the front plate 201. The display 220 may have a shape corresponding to the shape of the front plate 201, which may be one of a circle, an ellipse, and/or a polygon. The display 220 may be at least partially coupled to or disposed adjacent to a touch sensing circuit, a pressure sensor capable of measuring the intensity (pressure) of a touch, and or a fingerprint sensor.

The audio modules 205 and 208 may include a microphone hole 205 and a speaker hole 208. The microphone hole 205 may have a microphone disposed therein so as to acquire external sounds. In various embodiments, multiple microphones may be disposed such that the direction of sounds can be sensed. The speaker hole 208 may be used as an external speaker and a telephone speech receiver. In various embodiments, the speaker hole 208 and the microphone hole 205 may be implemented as a single hole, or a speaker (for example, a piezoelectric speaker) may be included without the speaker hole 208.

The sensor module 211 may generate an electric signal or a data value corresponding to the internal operating state of the electronic device 101, or external environment states. The sensor module 211 may include a biometric sensor module (for example, a biometric sensor, a heart rate monitor (HRM) sensor, an oxygen saturation sensor, and/or a blood glucose sensor) disposed toward the second surface 210B of the housing 210, for example. When the electronic device 101 is worn on a part of a human body (for example, on a wrist), the sensor module 211 may be disposed so as to at least partially contact the human body. The electronic device 101 may further include a sensor module not illustrated, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The key input devices 202, 203, and 204 may include a wheel key 202 disposed so as to correspond to the first surface 210A of the housing 210 and to be able to rotate along at least one direction (for example, clockwise, counterclockwise), and/or side key buttons 203 and 204 disposed on the lateral surface 210C of the housing 210. The wheel key 202 may have a shape corresponding to the shape of the front plate 201. According to an embodiment, the electronic device 101 may not include some or all of the above-mentioned key input devices 202, 203, and 204, and the key input devices 202, 203, and 204 not included may be implemented on the display 220 as soft keys or touch keys.

The connector hole 209 may contain a connector (for example, a USB connector) for transmitting/receiving power and/or data with an external electronic device (for example, the electronic devices 102 and 104 in FIG. 1). The electronic device 101 may further include, for example, a connector cover (not illustrated) configured to cover at least a part of the connector hole 209 and to prevent and/or reduce external foreign materials from infiltrating the connector hole 209.

The clamping members 250 and 260 may be detachably clamped in at least a partial region of the housing 210 using locking members 251 and 261. The clamping members 250 and 260 may include at least one of a retaining member 252, a retaining member fastening hole 253, a band guide member 254, and a band retaining ring 255. According to an embodiment, the electronic device 101 may remain clamped at least partially to a part of a human body (for example, on a wrist) using the clamping members 250 and 260.

The retaining member 252 may be at least partially coupled to the retaining member fastening hole 253 such that the housing 210 and the clamping members 250 and 260 are retained on a part of the user's body (for example, on a wrist or an ankle). The band guide member 254 may be configured such that, when the retaining member 252 is fastened to the retaining member fastening hole 253, the range of movement of the retaining member 252 is limited, thereby guaranteeing that the electronic device 101 is clamped to a part of the human body while the clamping members 250 and 260 maintain close contact with a part of the user's body. The band retaining ring 255 may limit the range of movement of the clamping members 250 and 260 while the retaining member 252 and the retaining member clamping hole 253 remain fastened to each other.

Referring to FIG. 4, the electronic device 101 may include a lateral bezel structure 206, a wheel key 202, a front plate 201, a display 220, a retaining member 460 (for example, a support member), a battery 470, a printed circuit board 480, a sealing member 490, and clamping members 250 and 260. For example, the retaining member 460 may be disposed inside the electronic device 101 and at least partially coupled to the lateral bezel structure 206, or may be formed integrally with the lateral bezel structure 206. The retaining member 460 may be made of a metal material and/or a nonmetal (for example, polymer) material. The display 220 may be coupled to one surface of the retaining member 460, and the printed circuit board 480 may be coupled to the other surface thereof. According to an embodiment, the battery 470 may be disposed between the retaining member 460 and the printed circuit board 480, and the retaining member 460 and the printed circuit board 480 may be electrically connected to each other. The retaining member 460 and the printed circuit board 480 may be electrically connected using a conductive member (for example, a screw or a metallic material). According to an embodiment, a processor (for example, the processor 120 in FIG. 1), a memory (for example, the memory 130 in FIG. 1), and/or an interface (for example, the interface 177 in FIG. 1) may be mounted on the printed circuit board 480. The processor 102 may include at least one of a central processing unit (CPU), an application processor (AP), a graphic processing unit (GPU), a sensor processor, or a communication processor (CP), for example.

The memory 130 may include, for example, a volatile memory or a nonvolatile memory. The interface may include, for example, at least one of a high definition multimedia interface (HDMI), a universal serial bus (USB) interface, an SD card interface, and/or an audio interface. The interface may connect, for example, the electronic device 101 and an external electronic device electrically or physically, and may include an USB connector, an SD card/multimedia card (MMC) connector, or an audio connector.

The battery 470 (for example, the battery 189 in FIG. 1) may be a device for supplying power to at least one component of the electronic device 101, and may include, for example, at least one of a primary battery which is not rechargeable, a secondary battery which is rechargeable, or a fuel cell. At least a part of the battery 470 may be disposed on substantially the same plane with the printed circuit board 480, for example. The battery 470 may be disposed integrally in the electronic device 101 or disposed to be attachable to/detachable from the electronic device 101.

The printed circuit board 480 may have at least one antenna (for example, an antenna module or a chip antenna) mounted thereon. For example, the at least one antenna may include at least one of a near field communication (NFC) antenna, a wirelessly charging antenna, and/or a magnetic secure transmission (MST) antenna. The at least one antenna may perform short-range communication with an external device, may wirelessly transmit/receive power necessary for charging, and may emit magnetically based signals including short-range communication signals or payment data. According to an embodiment, an antenna structure may be formed by at least some of the lateral bezel structure 206, the front plate 201, and/or the retaining member 460 or a combination thereof. According to an embodiment, the retaining member 460 and the printed circuit board 480 may be electrically connected, and an electronic field (E-field) may be formed based on the retaining member 460 and the printed circuit board 480. The electronic device 101 may transmit/receive communication signals, based on the formed E-field, and may use at least a part of the retaining member 460 as an antenna.

The sealing member 490 may include a seal and be positioned between the lateral bezel structure 206 and the rear plate 207. The sealing member 490 may be configured to prevent and/or reduce external moisture and foreign materials from infiltrating the space surrounded by the lateral bezel structure 206 and the rear plate 207.

The sensor module 211 (for example, a biometric sensor) may include at least one sensor and be disposed adjacent to the rear plate 207. For example, when the electronic device 101 is worn on a part of the wearer's body (for example, on a wrist), the rear plate 207 may be disposed so as to at least partially contact at least a part of the wearer's body. The sensor module 211 may be disposed so as to face a part of the wearer's body (for example, wrist or skin). The sensor module 211 may emit signals in various wavelength band with regard to a part of the wearer's body. The electronic device 101 may acquire various pieces of biometric information (for example, information related to the heart rate, blood glucose-related information, and/or oxygen saturation), based on signals in the wavelength bands which are reflected, scattered, and/or absorbed by a part of the wearer's body. According to an embodiment, the rear plate 207 may have a rear window 207a coupled thereto at least partially such that the above-mentioned signals are transmitted.

Referring to FIG. 5, the battery 470 may be disposed between the retaining member 460 and the printed circuit board 480 so as to supply power to at least one of the retaining member 460 and the printed circuit board 480. The retaining member 460 and the printed circuit board 480 may be electrically connected through at least one connection member 520 (for example, a conductive member, a conductive screw, or a metallic connection member). For example, the printed circuit board 480 may supply electric signals to the retaining member 460.

According to an embodiment, the thickness 510 of the battery 470 may change, based on the amount of remaining charge (for example, remaining capacity) of the battery 470. For example, the thickness 510 of the battery 470 may decrease as the remaining capacity of the battery 470 decreases. According to an embodiment, the retaining member 460 and the printed circuit board 480 may be disposed in a shape substantially identical to the shape of a capacitor (for example, in a structure in which the retaining member 460 and the printed circuit board 480 are disposed in parallel), and the retaining member 460 may perform at least partially the same function as the capacitor. For example, the electronic device 101 may form an E-field, based on the retaining member 460 and the printed circuit board 480, and may radiate communication signals using at least a part of the retaining member 460 as an antenna. According to an embodiment, the retaining member 460 and the printed circuit board 480 may implement an E-field corresponding to a first frequency band (for example, about 600MHz to about 900Mhz), and the retaining member 460 may be at least partially used as a radiator (for example, an antenna radiator). According to an embodiment, the E-field formed based on the retaining member 460 and the printed circuit board 480 may have a communication performance changed by a change in the thickness of the battery 470 disposed between the retaining member 460 and the printed circuit board 480. For example, the communication performance based on the E-field may deteriorate if the thickness of the battery 470 is reduced because the remaining capacity of the battery 470 has decreased.

According to an embodiment, the electronic device 101 may identify the remaining capacity of the battery 470 and may adjust a passive element value connected to the retaining member 460 (for example, a first antenna radiator or an antenna radiator corresponding to a first frequency band (for example, about 600MHz to about 900Mhz)) according to the identified remaining capacity of the battery 470. For example, if the identified remaining capacity of the battery 470 is below a configured threshold, the electronic device 101 may control a switch module (for example, an RF switch) such that the passive element value connected to the retaining member 460 increases. According to an embodiment, if the remaining capacity of the battery 470 decreases below a predetermined level (for example, a configured threshold), the electronic device 101 may adjust the passive element value connected to the retaining member 460 to be relatively large, and may maintain the communication performance based on the retaining member 460 to be optimal. The electronic device may maintain an optimal communication performance in a communication frequency band without being affected by the remaining battery capacity.

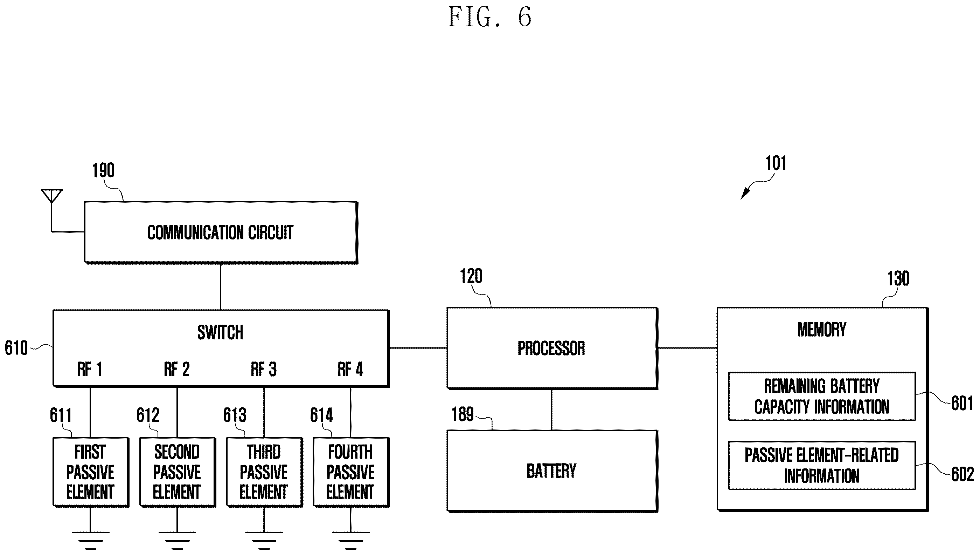

FIG. 6 is a block diagram illustrating an example configuration of an electronic device according to various embodiments.

The electronic device 101 in FIG. 6 (for example, the electronic device 101 in FIG. 1) may be at least partially similar to the electronic device 101 in FIG. 1, or may further include other configurations of the electronic device. For example, the electronic device 101 may include a wearable electronic device which can be worn on a part of a human body. The electronic device 101 may have a narrow internal space in which at least one component is to be mounted.

According to an embodiment, the electronic device 101 may use at least some of the components mounted therein as antenna radiators. For example, the electronic device 101 may include a retaining member (for example, the retaining member 460 in FIG. 4) for retaining at least one component (for example, the battery 470 in FIG. 4), and a printed circuit board (for example, the printed circuit board 480 in FIG. 4) on which at least one passive element (for example, an inductor, a capacitor, or a resistor) is disposed, and a battery 470 may be disposed between the retaining member 460 and the printed circuit board 480. The electronic device 101 may use at least partially the retaining member 460 as an antenna radiator. For example, the retaining member 460 and the printed circuit board 480 may be electrically connected through a connection member (for example, the connection member 520 in FIG. 5 or a conductive member). According to an embodiment, an E-field may be formed based on the retaining member 460 and the printed circuit board 480, and the electronic device 101 may transmit/receive communication signals, based on the formed E-field. The electronic device 101 may use at least a part of the retaining member 460 as an antenna radiator.

According to an embodiment, the battery 470 disposed between the retaining member 460 and the printed circuit board 480 may at least partially influence formation of an E-field. For example, the thickness of the battery 470 may change according to the remaining capacity (for example, the amount of remaining charge) of the battery 470, and the communication performance based on the E-field may change as the thickness of the battery 470 changes. For example, if the remaining capacity of the battery 470 decreases below a configured threshold, the thickness of the battery 470 becomes relatively small. If the thickness of the battery 470 disposed between the retaining member 460 and the printed circuit board 480 decreases, the communication performance that follows the E-field formed based on the retaining member 460 and the printed circuit board 480 may deteriorate.

According to an embodiment, the electronic device 101 may identify the remaining capacity of the battery 470 and may change a passive element (for example, a capacitor) connected to the retaining member 460 in response to a situation in which the remaining capacity of the battery 470 drops below a configured threshold. For example, the retaining member 460 may be in a state in which the same is electrically connected to multiple passive elements disposed on the printed circuit board 480 through a switch module (for example, an RF switch). The electronic device 101 may control the switch module such that at least one of the multiple passive elements is electrically connected to the retaining member 460. For example, the passive element may include a capacitor, and the description that the passive element is connected to the retaining member 460 may refer, for example, to the capacitor value of the capacitor being supplied to the retaining member 460. For example, if a passive element (for example, a second capacitor) is additionally connected to the retaining member 460 while a first capacitor (for example, a first capacitor value) is connected to the retaining member 460, a third capacitor value corresponding to the sum of the first capacitor value of the first capacitor and the second capacitor value of the second capacitor may be applied to the retaining member 460. If a passive element (for example, a capacitor) is connected to the retaining member 460, a passive element value based on the passive element (for example, a capacitor value based on a capacitor) may be additionally applied to the retaining member 460.

According to an embodiment, the electronic device 101 may control the switch circuit such that first and second passive elements are together connected to the retaining member 460. In this case, a first passive element value according to the first passive element and a second passive element value according to the second passive element may be summated in parallel and supplied to the retaining member 460. The electronic device 101 may supply a relatively high passive element value (for example, a capacitor value), based on a first frequency band corresponding to the retaining member 460, and may optimize and implement the communication performance according to the first frequency band. The electronic device 101 may enhance the communication efficiency in the first frequency band.

Referring to FIG. 6, the electronic device 101 may include a processor (e.g., including processing circuitry) (for example, the processor 120 in FIG. 1) 120, a memory (for example, the memory 130 in FIG. 1) 130, a switch 610, a battery (for example, the battery 189 in FIG. 1) 189, and/or a communication circuit (for example, the communication module 190 in FIG. 1) 190. For example, the processor 120 of the electronic device 101 may be connected to the memory 130, the battery 189, the switch 610, and the communication circuit 190 operatively or electrically. According to an embodiment, the description that hardware elements of the electronic device 101 are operatively coupled may refer, for example, to direct connection or indirect connection in a wired or wireless type being established between the hardware elements such that, among the hardware elements, the second hardware element is controlled by the first hardware element. The processor 120 may at least partially control the switch 610 such that at least one of the multiple passive elements 611, 612, 613, and 614 is connected to the communication circuit 190. According to an embodiment, the electronic device 101 may select a passive element to be connected to the communication circuit 190, based on the remaining capacity of the battery 189, and may control the switch 610 such that the selected passive element is connected to the communication circuit 190. The electronic device 101 may increase the capacitor value supplied to the communication circuit 190 in response to a situation in which the remaining capacity of the battery 189 drops below a configured threshold, thereby implementing communication performance more efficiently.

According to an embodiment, the processor 120 of the electronic device 101 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may, for example, execute a program (for example, the program 140 in FIG. 1) stored in the memory 130 so as to control at least one other component (for example, hardware or software component) and to perform various kinds of data processing or computation. For example, the processor 120 may identify the remaining capacity of the battery 189 and may at least partially control the switch 610 such that at least one passive element is connected to the communication circuit 190 in response to a situation in which the remaining capacity of the battery 189 drops below a configured threshold. According to an embodiment, the processor 120 may be connected to the memory 130, the battery 189, the switch 610, and/or the communication circuit 190 operatively, functionally, and/or electrically.

According to an embodiment, the memory 130 may store remaining battery capacity information 601 including information regarding at least one threshold (for example, a first threshold and a second threshold) in connection with the remaining capacity of the battery 189. For example, the processor 120 may determine, based on the remaining battery capacity information 601 stored in the memory 130, whether the remaining capacity of the battery 189 has dropped below a first threshold or whether the remaining capacity of the battery 189 has dropped below a second threshold. For example, the first threshold and the second threshold may include a reference value for triggering the switch 610.

According to an embodiment, the memory 130 may store information (for example, passive element-related information 602) regarding at least one passive element connected to the communication circuit 190 according to the remaining capacity of the battery. For example, the passive element-related information 602 may include information regarding a first passive element connected to the communication circuit 190 in response to a situation in which the remaining capacity of the battery 189 is below a first threshold, and information regarding a second passive element connected to the communication circuit 190 in response to a situation in which the remaining capacity of the battery 189 is below a second threshold.

According to an embodiment, the passive element-related information 602 may include information regarding a combination of at least one passive selected element, based on multiple passive elements 611, 612, 613, and 614. For example, a total of four passive elements including a first passive element 611, a second passive element 612, a third passive element 613, and a fourth passive element 614 may be combined in about 16 combination types.

**Table 1]**

| Battery remaining capacity information | Combination type | Configuration information |
|---|---|---|
| First threshold | RF1 | 0 |
| Second threshold | RF2 | 1 |
| Third threshold | RF1+RF2 | 2 |
| ... | ... | ... |
| 14^{th} threshold | RF3+RF4 | 13 |
| 15^{th} threshold | RF2+RF3+RF4 | 14 |
| 16^{th} threshold | RF1+ RF2+RF3+RF4 | 15 |

Referring to [Table 1], the processor 120 may configure multiple thresholds (for example, about 16 thresholds) and may configure combination types corresponding to respective thresholds. For example, the processor 120 may select the first passive element 611 (for example, RF1), based on passive element-related information 602 (for example, Table 1), in response to a situation in which the remaining capacity of the battery 189 drops below a first threshold, and may control the switch 610 such that the first passive element 611 is connected to the communication circuit 190. For example, the processor 120 may select the first passive element 611 (for example, RF1) and the second passive element 612 (for example, RF2) together, based on passive element-related information 602 (for example, Table 1), in response to a situation in which the remaining capacity of the battery 189 drops below a third threshold, and may control the switch 610 such that the first passive element 611 and the second passive element 612 are connected to the communication circuit 190 simultaneously or together. If multiple passive elements are connected simultaneously or together, a first passive element value according to the first passive element 611 and a second passive element value according to the second passive element 612 may be summated and applied to the communication circuit 190.

According to an embodiment, the processor 120 may select a combination type corresponding to each of the multiple thresholds, and may store the same passive element-related information 602 in the memory 130.

According to an embodiment, the processor 120 may sense a situation in which the remaining capacity of the battery 189 drops below a configures threshold, based on remaining battery capacity information 601. In response to sensing the situation, the processor 120 may identify a combination type configured so as to correspond to the configured threshold, based on the passive element-related information 602. The processor 120 may select at least one of the multiple passive elements 611, 612, 613, and 614 according to the identified combination type, and may control the switch 610 such that the at least one selected passive element is connected to the communication circuit 190.

According to an embodiment, the switch 610 may electrically connect at least one of the multiple passive elements 611, 612, 613, and 614 to the communication circuit 190 under the control of the processor 120. For example, the switch 610 may include an RF switch, a switch device, and/or a switch circuit. According to an embodiment, the processor 120 may control the switch 610 such that at least one passive element is connected to the communication circuit 190. For example, if the first passive element 611 is connected to the communication circuit 190, a first passive element value corresponding to the first passive element 611 may be applied to the communication circuit 190. For example, if the first passive element 611 is a first capacitor, the first passive element value may include a first capacitor value of the first capacitor. As another example, if the first passive element 611 and the second passive element 612 are connected to the communication circuit 190, the first passive element 611 and the second passive element 612 may be connected to the communication circuit 190 in a parallel manner, and a first passive element value corresponding to the first passive element 611 and a second passive element value corresponding to the second passive element 612 may be summated and applied to the communication circuit 190. As an example, if a first passive element 611 having a first capacitor value C1, a second passive element 612 having a second capacitor value C2, and a third passive element 613 having a third capacitor value C3 are connected in parallel through the switch 610, the total capacitor value (Ctotal=C1 +C2+C3) may be used for antenna resonance in a specific frequency band. According to an embodiment, if multiple passive elements are connected in parallel, the electronic device 101 may summate the passive element values according to the multiple passive elements, and may apply the sum of passive element values to the retaining member 460.

According to an embodiment, the processor 120 may summate passive element values according to respective multiple passive elements, based on at least one passive element connected to the communication circuit 190, and may supply the sum of passive element values to the communication circuit 190.

According to an embodiment, the communication circuit 190 may be electrically connected to at least one antenna corresponding to multiple communication frequency bands, and may perform multiple kinds of communication based on the multiple communication frequency bands. For example, the electronic device 101 may use some of the components included in the housing (for example, the housing 210 in FIG. 2) as an antenna (for example, an antenna radiator). According to an embodiment, the electronic device 101 may include a structure in which a printed circuit board (for example, the printed circuit board 480 in FIG. 4) is electrically connected to a retaining member (for example, the retaining member 460 in FIG. 4) through a conductive member (for example, the conductive member 520 in FIG. 5). The processor 120 may use at least a part of the retaining member 460, or a conductive material deposited at least partially on the retaining member 460, as an antenna (for example, an antenna radiator). For example, the retaining member 460 may function as an antenna radiator corresponding to a first frequency band.

According to an embodiment, the retaining member 460 and the printed circuit board 480 may be disposed side by side, like a capacitor, and may substantially function as a capacitor. For example, the electronic device 101 may form an E-field (for example, an E-field corresponding to a first communication frequency band), based on the retaining member 460 and the printed circuit board 480, and may transmit/receive communication signals using the formed E-field.

According to an embodiment, the processor 120 may identify the remaining capacity of the battery 189 at a configured cycle or timepoint, and may sense a situation in which the remaining capacity of the battery 189 drops below a configured threshold. In response to sensing the situation, the processor 120 may electrically connect at least one passive element to the retaining member 460. For example, the processor 120 may control the switch 610 such that multiple passive elements are connected to the retaining member 460, and may apply the sum of passive element values according to the multiple passive elements to the retaining member 460. According to an embodiment, in connection with forming an E-field corresponding to a first communication frequency band, the electronic device 101 may adjust the passive element value applied to the retaining member 460, and may implement optimal communication performance according to a first communication frequency.

According to an example embodiment, an electronic device (for example, the electronic device 101 in FIG. 1) may include: a battery (for example, the battery 470 in FIG. 5), a retaining member comprising a support (for example, the retaining member 460 in FIG. 5) disposed on one surface of the battery and configured to function as an antenna corresponding to a first frequency band (for example, about 600Mhz to about 900Mhz), and a printed circuit board (for example, the printed circuit board 480 in FIG. 5) disposed on an other surface of the battery, the printed circuit board including a communication circuit (for example, the communication circuit 190 in FIG. 1 and FIG. 6) electrically connected to the retaining member. According to an embodiment, the electronic device may include a switch (for example, the switch 610 in FIG. 6 or an RF switch) configured to electrically connect at least one passive element among multiple passive elements and the retaining member, a memory (for example, the memory 130 in FIG. 1 and FIG. 6), and at least one processor, comprising processing circuitry (for example, the processor 120 in FIG. 1 and FIG. 6), operatively connected to the communication circuit 190, the switch 610, and the memory 130. According to an embodiment, at least one processor, individually and/or collectively, may be configured to: identify the remaining capacity of the battery; identify information regarding a passive element to be connected to the retaining member, based on the identified remaining capacity of the battery and the first frequency band; select at least one passive element among the multiple passive elements, based on the identified information regarding a passive element; and control the switch such that the at least one selected passive element and the retaining member are electrically connected.

According to an example embodiment, the retaining member and the printed circuit board may be electrically connected using at least one conductive member comprising a conductive material (for example, the conductive member 520 in FIG. 5 or a connection member).

According to an example embodiment, the retaining member may include at least one antenna element configured to be used as an antenna radiator.

According to an example embodiment, the retaining member and the printed circuit board may be disposed in parallel, corresponding substantially to a capacitor shape.

According to an example embodiment, at least one processor, individually and/or collectively, may be configured to identify an electric field (for example, E-field) generated based on the retaining member and the printed circuit board, disposed in substantially the capacitor shape, and control the communication circuit to transmit/receive communication signals, based on the identified electronic field.

According to an example embodiment, the battery may be disposed between the retaining member and the printed circuit board, and a thickness of the battery may be at least partially changed according to a remaining capacity of the battery.

According to an example embodiment, at least one processor, individually and/or collectively, may be configured to identify whether the identified remaining capacity of the battery is below a configured threshold; and select the at least one passive element corresponding to the first frequency band in response to the remaining capacity of the battery being below the configured threshold.

According to an example embodiment, the at least one passive element may include at least one capacitor, inductor, or resistor.

According to an example embodiment, based on a first passive element and a second passive element being selected together among the multiple passive elements, at least one processor, individually and/or collectively, may be configured to: control the switch such that the first passive element and the second passive element are electrically connected to the retaining member; add a first passive element value corresponding to the first passive element and a second passive element value corresponding to the second passive element ; and apply the added passive element values to the retaining member.

According to an example embodiment, the first frequency band may include a band in a range of about 600Mhz to about 900Mhz; the retaining member may include stainless steel (SUS) plate; and at least one passive element may include at least one of at least one capacitor, at least one inductor, and at least one resistor.

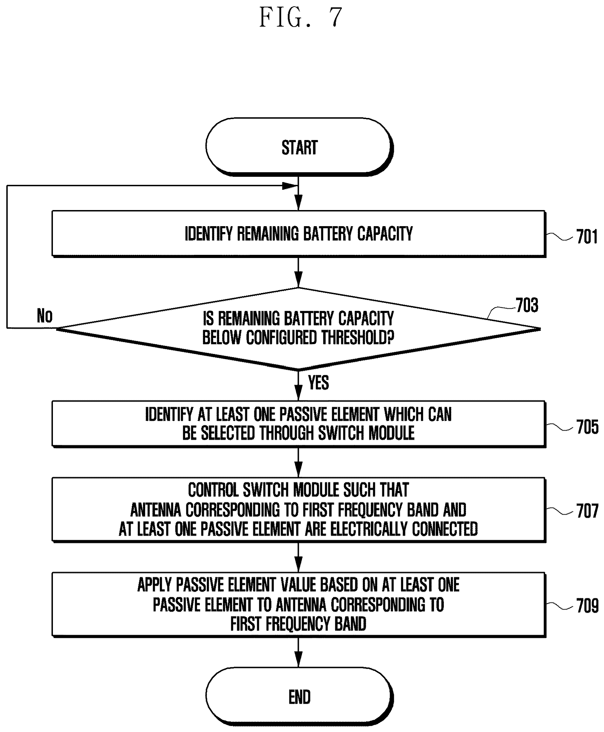

FIG. 7 is a flowchart illustrating an example method for connecting a passive element to an antenna radiator of an electronic device according to various embodiments.

Respective operations in the following example embodiment may be performed successively, but are not necessarily performed successively. For example, the order of respective operations may be changed, and at least two operations may be performed in parallel.

According to an embodiment, operations 701 to 709 may be understood as being performed by a processor (for example, the processor 120 in FIG. 1 to FIG. 6) of an electronic device (for example, the electronic device 101 in FIG. 1 to FIG. 6).

The electronic device 101 in FIG. 7 may be at least partially similar to the electronic device 101 in FIG. 1 to FIG. 6, or may further include other configurations of the electronic device. The electronic device 101 may use some of the components included in the housing (for example, the housing 210 in FIG. 2) as an antenna (for example, an antenna radiator). According to an embodiment, the electronic device 101 may include a structure in which a printed circuit board (for example, the printed circuit board 480 in FIG. 4) and a retaining member (for example, the retaining member 460 in FIG. 4) are electrically connected through a conductive member (for example, the conductive member 520 in FIG. 5). For example, the processor 120 of the electronic device 101 may apply a configured passive element value to the retaining member 460, and may form an E-field (for example, an E-field corresponding to a first communication frequency band (for example, about 600Mhz to about 900Mhz), based on the retaining member 460 and the printed circuit board 480. The processor 120 may transmit/receive communication signals using an E-field corresponding to a first communication frequency band.

The electronic device 101 in FIG. 7 may have a battery (for example, the battery 189 in FIG. 1 to FIG. 6 or the battery 470 in FIG. 5) disposed between the retaining member 460 and the printed circuit board 480. For example, the thickness (for example, the thickness 510 in FIG. 5) of the battery 470 may change at least partially according to the remaining capacity of the battery 470. If the remaining capacity of the battery 470 increases, the thickness 510 of the battery 470 may be relatively large, and if the remaining capacity of the battery 470 decreases, the thickness 510 of the battery 470 may be relatively small.

In operation 701, the processor 120 of the electronic device 101 may identify the remaining capacity (for example, the amount of remaining charge or the remaining battery capacity) of the battery (for example, the battery 189 in FIG. 1) at a configured cycle or timepoint. For example, the processor 120 may identify the remaining capacity of the battery 189 in real time, and may display the identified remaining capacity of the battery 189 through a display (for example, a display module 160). According to an embodiment, the processor 120 may correspond to the main processor 121 in FIG. 1, and may identify the remaining capacity of the battery 189 periodically or at a designated timepoint.

In operation 703, the processor 120 may determine whether the remaining capacity of the battery 189 is below a configured threshold, based on remaining battery capacity information (for example, the remaining battery capacity 601 in FIG. 6). For example, the remaining battery capacity information 601 may include the ratio (for example, threshold) of the remaining battery capacity against the entire battery capacity. The remaining battery capacity information 601 may include at least one preconfigured threshold. The processor 120 may sense whether the remaining capacity of the battery 189 drops below a configured threshold at a configured cycle or timepoint. In the case of a situation (for example, "No" in operation 703) in which the remaining capacity of the battery 189 is equal to/larger than the configured threshold in operation 703, the processor 120 may continuously identify the remaining capacity of the battery 189 at the configured cycle or timepoint in operation 701.

In the case of a situation (for example, "Yes" in operation 703) in which the remaining capacity of the battery 189 is below than the configured threshold in operation 703, the processor 120 may identify at least one passive element which can be selected through a switch module (for example, the switch module 610 in FIG. 6) in operation 705. For example, the at least one passive element may be electrically connected to a retaining member (for example, the retaining member 460 in FIG. 4 and FIG. 5) used as an antenna radiator, through the switch 610. For example, the at least one passive element may be disposed on a printed circuit board (for example, the printed circuit board 480 in FIG. 4 and FIG. 5), and may include at least one of a capacitor, an inductor, and a resistor. The at least one passive element may include at least one capacitor, and may apply a passive element value to the retaining member 460 under the control of the switch 610. For example, if the first passive element (for example, the first passive element 611 in FIG. 6) and the second passive element (for example, the second passive element 612 in FIG. 6) are selected simultaneously or together by the switch 610, the first passive element value corresponding to the first passive element 611 and the second passive element value corresponding to the second passive element 612 may be summated, and the sum of the passive element values (for example, a third passive element value) may be applied to the retaining member 460.

In operation 707, the processor 120 may control the switch 610 such that an antenna (for example, a retaining member 460) corresponding to a first frequency band (for example, about 600Mhz to about 900Mhz) and at least one passive element are electrically connected. For example, the processor 120 may identify at least one passive element configured so as to correspond to the first frequency band, based on passive element-related information (for example, the passive element-related information 602 in FIG. 6) stored in the memory 130, and may control the switch 610 such that the identified passive element is connected to the antenna (for example, the retaining member 460).

According to an embodiment, the processor 120 may include an application processor (AP) corresponding to the main processor 121 in FIG. 1, and a communication processor (CP) corresponding to the auxiliary processor 123 in FIG. 1. In operation 707, the main processor (for example, application processor (AP)) may request the auxiliary processor (for example, communication processor (CP)) to select at least one passive element. The auxiliary processor (for example, communication processor (CP)) may control the switch 610 such that an antenna (for example, a retaining member 460) and at least one passive element are connected, in response to the request of the main processor (for example, application processor (AP)).

In operation 709, the processor 120 may apply a passive element value based on at least one passive element to an antenna (for example, a retaining member 460) corresponding to a first frequency band (for example, about 600Mhz to about 900Mhz). For example, if multiple passive elements, that is, a first passive element 611 and a second passive element 612 are connected together to the retaining member 460, a first passive element value corresponding to the first passive element 611 and a second passive element value corresponding to the second passive element 612 may be summated, and the sum of passive element values may be applied to the retaining member 460. For example, if the at least one passive element is a first capacitor, the passive element value may include a first capacitor value corresponding to the first capacitor.

According to an embodiment, in connection with performing communication based on a first frequency band, the sum of passive element values may be applied to the electronic device 101 such that more efficient communication performance is implemented. For example, the first frequency band (for example, about 600Mhz to about 900Mhz) may be classified as a relatively low frequency band, and the communication performance in the first frequency band may be relatively heavily influenced by a change in peripheral communication environment (for example, a change in thickness of the battery 470). In connection with performing communication based on a first frequency band, the electronic device 101 may apply a relatively high passive element value to the antenna (for example, retaining member 460). The electronic device 101 may implement more efficient communication performance, based on the first frequency band.

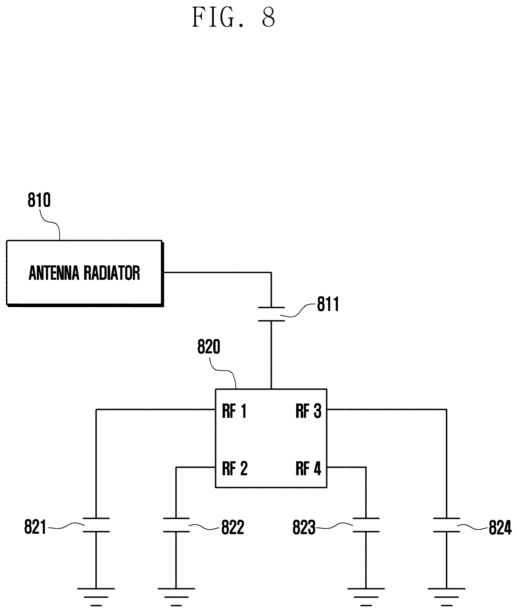

FIG. 8 is a circuit diagram illustrating an example configuration of a switch module configured to electrically connect an antenna radiator and a passive element according to various embodiments.

The electronic device 101 in FIG. 8 may be at least partially similar to the electronic device 101 in FIG. 1 to FIG. 6, or may further include other configurations of the electronic device. The electronic device 101 may use some of the components included in the housing (for example, the housing 210 in FIG. 2) as an antenna radiator 810 (for example, an SUS plate or the retaining member 460 in FIG. 5). According to an embodiment, the electronic device 101 may include a structure in which a printed circuit board (for example, the printed circuit board 480 in FIG. 4) and an antenna radiator 810 (for example, the retaining member 460 in FIG. 4) are electrically connected through a conductive member (for example, the conductive member 520 in FIG. 5).

Referring to FIG. 8, the electronic device 101 may include a switch module 820 (for example, the switch 610 in FIG. 6) such that the antenna radiator 810 and at least one passive element (for example, a first passive element 821, a second passive element 822, a third passive element 823, and a fourth passive element 824) are electrically connected. For example, the at least one passive element may be at least partially mounted on the printed circuit board 480, and each passive element may include at least one of at least one capacitor, at least one inductor, and at least one resistor.

According to an embodiment, if the first passive element 821 is connected to the antenna radiator 810, a first passive element value corresponding to the first passive element 821 may be applied to the antenna radiator 810. According to an embodiment, if the first passive element 821 and the second passive element 822 are connected together to the antenna radiator 810, the first passive element value corresponding to the first passive element 821 and the second passive element value corresponding to the second passive element 822 may be summated and applied to the antenna radiator 810.

Referring to FIG. 8, a (1-1)^{th} passive element 811 may be disposed between the antenna radiator 810 and the switch module 820. For example, when connecting the first passive element 821, the electronic device 101 may sum passive element values according to the (1-1)^{th} passive element 811 and the first passive element 821 and may apply the sum to the antenna radiator 810. When connecting the second passive element 822, the electronic device 101 may summate passive element values according to the (1-1)^{th} passive element 811 and the second passive element 822 and may apply the sum to the antenna radiator 810.

According to an embodiment, the electronic device 101 may identify a first frequency band corresponding to the antenna radiator 810, and may identify the type and number of preconfigured passive elements, in connection with the identified first frequency band, based on passive element-related information (for example, the passive element-related information 602 in FIG. 6) stored in the memory (for example, the memory 130 in FIG. 6). The electronic device 101 may control the switch module 820 such that the antenna radiator 810 and the preconfigured passive elements are electrically connected.

Although the (1-1)^{th} passive element 811 is illustrated in FIG. 8 as being disposed between the antenna radiator 810 and the switch module 820, the configuration of the (1-1)^{th} passive element 811 may be omitted. According to an embodiment, the structure in which the antenna radiator 810 and at least one passive element are disposed is not limited to the structure illustrated in FIG. 8.

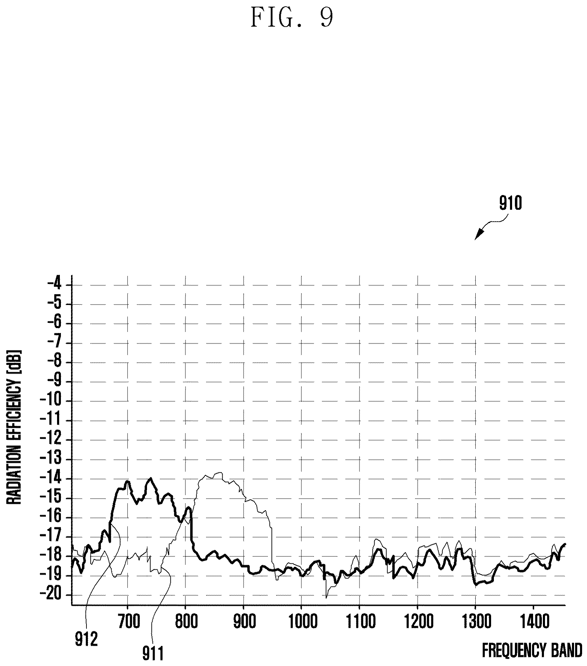

FIG. 9 is a graph 910 illustrating a change in radiation efficiency according to connection of a passive element according to various embodiments.

The electronic device 101 in FIG. 9 may be at least partially similar to the electronic device 101 in FIG. 1 to FIG. 6, or may further include other configurations of the electronic device. The electronic device 101 may use some of the components included in the housing (for example, the housing 210 in FIG. 2) as an antenna radiator 810 (for example, an SUS plate or the retaining member 460 in FIG. 5). According to an embodiment, the electronic device 101 may include a structure in which a printed circuit board (for example, the printed circuit board 480 in FIG. 4) and an antenna radiator 810 (for example, the retaining member 460 in FIG. 4) are electrically connected through a conductive member (for example, the conductive member 520 in FIG. 5).

The electronic device 101 in FIG. 9 may include a structure in which a battery (for example, the battery 189 in FIG. 1 and FIG. 6, or the battery 470 in FIG. 5) is disposed between a retaining member 460 and a printed circuit board 480. For example, the thickness (for example, the thickness 510 in FIG. 5) of the battery 470 may change at least partially according to the remaining capacity of the battery 470. If the remaining capacity of the battery 470 increases, the thickness 510 of the battery 470 may be relatively large, and if the remaining capacity of the battery 470 decreases, the thickness 510 of the battery 470 may be relatively small.

According to an embodiment, the electronic device 101 may use a capacitor function, based on the retaining member 460 and the printed circuit board 480, and may perform communication in a first frequency band (for example, about 600Mhz to about 900Mhz) corresponding to the retaining member 460.

FIG. 9 illustrates a first graph 911 indicating radiation efficiency regarding an antenna radiator (for example, retaining member 460) in a situation in which the remaining capacity of the battery 470 is below a configured threshold, and a second graph 912 indicating radiation efficiency in a state in which at least one passive element (for example, the passive elements 611, 612, 613, and 614 in FIG. 6) is additionally applied to the antenna radiator (for example, retaining member 460).

The first graph 911 shows a relatively degraded radiation efficiency as the remaining capacity of the battery 470 drops below a configured threshold. For example, the radiation efficiency has dropped in a band of about 650Mhz to about 800Mhz.

The second graph 912 indicates that, in response to a situation in which the remaining capacity of the battery 470 drops below a configured threshold, at least one passive element may be connected to the antenna radiator (for example, retaining member 460), and shows a relatively improved radiation efficiency compared with the first graph 911. For example, the radiation efficiency is optimized in the band of about 650Mhz to about 800Mhz compared with the first graph 911. The second graph 912 shows a radiation efficiency in a state in which an additional passive element (for example, a capacitor) is electrically connected to the antenna radiator (for example, retaining member 460), compared with the first graph 911, and in which a relatively high passive element value is applied to the antenna radiator. For example, at least one passive element may be electrically connected to the antenna radiator (for example, retaining member 460), thereby optimizing the radiation efficiency in a specific frequency band.

According to an embodiment, the radiation efficiency (for example, communication performance) in a specific frequency band may vary depending on the remaining battery capacity. The electronic device 101 may electrically connect at least one passive element to the antenna radiator (for example, retaining member 460), thereby additionally applying a passive element value to the antenna radiator, and adjusting the radiation efficiency in a specific frequency band. For example, the electronic device 101 may adjust the first radiation efficiency according to the first graph 911 to the second radiation efficiency according to the second graph 912, based on a specific frequency band (for example, about 650Mhz to about 800Mhz). The electronic device 101 may optimize the radiation efficiency in the specific frequency band (for example, about 650Mhz to about 800Mhz).

According to an embodiment, the processor 120 (for example, the processor 120 in FIG. 6) of the electronic device 101 may determine, based on remaining battery capacity information (for example, the remaining battery capacity information 601 in FIG. 6) stored in the memory (for example, the memory 130 in FIG. 6), whether the remaining capacity of the battery 470 has dropped below a first threshold. In response to a situation in which the remaining capacity of the battery 470 drops below a configured threshold, the processor 120 may identify at least one passive element (for example, the passive elements 611, 612, 613, and 614 in FIG. 6) which can be connected to an antenna radiator (for example, retaining member 460) corresponding to a first frequency band (for example, about 600Mhz to about 900Mhz). The processor 120 may select at least one from the multiple passive elements 611, 612, 613, and 614, based on passive element-related information (for example, the passive element-related information 602 in FIG. 6) stored in the memory 130. The processor 120 may control the switch module (for example, the switch 610 in FIG. 6) such that the antenna radiator (for example, retaining member 460) and the at least one selected passive element are connected. For example, if a passive element is connected to the antenna radiator, a passive element value corresponding to the passive element may be applied to the antenna radiator. If multiple passive elements are connected to the antenna radiator, passive element values regarding the passive elements may be summated and applied to the antenna radiator. For example, the passive elements may include circuit components that affect the radiation efficiency (for example, communication efficiency), such as a capacitor, an inductor, and/or a resistor.

According to an embodiment, the electronic device 101 may select at least one passive element to be connected to the antenna radiator (for example, retaining member 460) in response to a situation in which the remaining capacity of the battery 470 drops below a configured threshold (for example, a situation in which the communication performance in the first frequency band deteriorates due to a change in thickness of the battery 470). The passive element value corresponding to the at least one selected passive element may be applied to the antenna radiator. The electronic device 101 may implement more efficient communication performance according to the communication frequency band (for example, the first frequency band) regardless of any change in the remaining capacity of the battery 470. The electronic device 101 may connect at least one passive element to the antenna radiator (for example, retaining member 460) such that the communication performance in the first frequency band is further improved.

According to an example embodiment, a method for connecting a passive element to an antenna may include: identifying a remaining capacity of a battery (for example, the battery 470 in FIG. 5) disposed between a retaining member (for example, the retaining member 460 in FIG. 5) configured to function as an antenna corresponding to a first frequency band and a printed circuit board (for example, the printed circuit board 480 in FIG. 5) including a communication circuit (for example, the communication circuit 190 in FIG. 1 and FIG. 6) electrically connected to the retaining member, identifying information regarding a passive element to be connected to the retaining member, based on the identified remaining capacity of the battery and the first frequency band, selecting at least one passive element among multiple passive elements, based on the identified information regarding a passive element, and controlling a switch such that the at least one selected passive element and the retaining member are electrically connected.

According to an example embodiment, the retaining member and the printed circuit board are electrically connected using at least one conductive member (for example, the conductive member 520 in FIG. 5 or a connection member).

According to an example embodiment, the retaining member may include at least one antenna element configured to be used as an antenna radiator.

According to an example embodiment, the retaining member and the printed circuit board may be disposed in parallel, in substantially a capacitor shape.

According to an example embodiment, the method may further include identifying an electric field (for example, E-field) generated based on the retaining member and the printed circuit board, disposed in substantially the capacitor shape, and transmitting/receiving communication signals, based on the identified electric field.

According to an example embodiment, the battery may be disposed between the retaining member and the printed circuit board, and the thickness of the battery may be at least partially changed according to the remaining capacity of the battery.

According to an example embodiment, selecting at least one passive element may include identifying whether the identified remaining capacity of the battery is below a configured threshold, and selecting at least one passive element corresponding to the first frequency band in response to the remaining capacity of the battery being below the configured threshold.

According to an example embodiment, the at least one passive element may include at least one of at least one capacitor, at least one inductor, and at least one resistor.

According to an example embodiment, the method may further include, based on a first passive element and a second passive element being selected together among the multiple passive elements, controlling the switch such that the first passive element and the second passive element are electrically connected to the retaining member, summing a first passive element value corresponding to the first passive element and a second passive element value corresponding to the second passive element, and applying the sum of passive element values to the retaining member.

According to an example embodiment, the first frequency band may include a band in a range of about 600Mhz to about 900Mhz. The retaining member may include stainless steel (SUS) plate. The at least one passive element may include at least one of at least one capacitor, at least one inductor, and at least one resistor.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. It is intended that features described with respect to separate embodiments, or features recited in separate claims, may be combined unless such a combination is explicitly specified as being excluded or such features are incompatible. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device (101) comprising:
a battery (470);
a retaining member (460) comprising a support disposed on one surface of the battery (470) and configured to function as an antenna corresponding to a first frequency band;
a printed circuit board (480) disposed on an other surface of the battery (470), the printed circuit board comprising a communication circuit (190) electrically connected to the retaining member (460);
a switch (610) configured to electrically connect at least one passive element among multiple passive elements and the retaining member (460);
memory (130); and
at least one processor (120), comprising processing circuitry, operatively connected to the communication circuit (190), the switch (610), and the memory (130),
wherein at least one processor (120), individually and/or collectively, is configured to:
identify a remaining capacity of the battery (470);
identify information regarding a passive element (602) to be connected to the retaining member (460), based on the identified remaining capacity of the battery (470) and the first frequency band;
select at least one passive element among the multiple passive elements, based on the identified information regarding a passive element (602); and
control the switch (610) such that the at least one selected passive element and the retaining member (460) are electrically connected.

2. The electronic device of claim 1, wherein the retaining member (460) and the printed circuit (480) board are electrically connected using at least one conductive member (520) comprising a conductive material.

3. The electronic device of claim 1, wherein the retaining member (460) comprises at least one antenna element configured to be used as an antenna radiator.

4. The electronic device of claim 1, wherein the retaining member (460) and the printed circuit board (480) are disposed in parallel, to have a substantially capacitor shape.

5. The electronic device of claim 1, wherein at least one processor (120), individually and/or collectively, is configured to:
identify an electric field generated based on the retaining member (460) and the printed circuit board (480), disposed in substantially the capacitor shape; and
control the electronic device to transmit/receive communication signals, based on the identified electric field.

6. The electronic device of claim 1, wherein the battery (470) is disposed between the retaining member (460) and the printed circuit board (480), and a thickness of the battery (470) is at least partially changed according to the remaining capacity of the battery (470).

7. The electronic device of claim 1, wherein at least one processor (120), individually and/or collectively, is configured to:
identify whether an identified remaining capacity of the battery (470) is below a configured threshold; and
select the at least one passive element corresponding to the first frequency band in response to a situation in which the remaining capacity of the battery (470) is below the configured threshold.

8. The electronic device of claim 1, wherein the threshold is configured as a first threshold and a second threshold according to the remaining capacity of the battery (470), and
wherein at least one processor (120), individually and/or collectively, is configured to:
select at least one passive element configured based on the first threshold in response to a remaining capacity of the battery (470) being below the first threshold; and
select at least one passive element configured based on the second threshold in response to the remaining capacity of the battery (470) being below the second threshold.

9. The electronic device of claim 1, wherein at least one processor (120), individually and/or collectively, is configured to:
based on a first passive element (611) and a second passive element (612) being selected together among the multiple passive elements, control the switch (610) such that the first passive element (611) and the second passive element (612) are electrically connected to the retaining member (460);
sum a first passive element value corresponding to the first passive element (611) and a second passive element value corresponding to the second passive element (612); and
apply the sum of passive element values to the retaining member (460).

10. The electronic device of claim 1, wherein the first frequency band comprises a band in a range of about 600Mhz to about 900Mhz,
wherein the retaining member (460) comprises stainless steel (SUS) plate, and
wherein the at least one passive element comprises at least one of at least one capacitor, at least one inductor, and at least one resistor.

11. A method for connecting a passive element to an antenna, the method comprising:
identifying a remaining capacity of a battery (470) disposed between a retaining member (460) configured to function as an antenna corresponding to a first frequency band and a printed circuit board (480) comprising a communication circuit (190) electrically connected to the retaining member (460);
identifying information regarding a passive element (602) to be connected to the retaining member (460), based on the identified remaining capacity of the battery (470) and the first frequency band;
selecting at least one passive element among multiple passive elements, based on the identified information regarding a passive element (602); and
controlling a switch (610) such that the at least one selected passive element and the retaining member (460) are electrically connected.

12. The method of claim 11, wherein the selecting of at least one passive element comprises:
identifying whether the identified remaining capacity of the battery (470) is below a configured threshold; and
selecting the at least one passive element corresponding to the first frequency band in response to a situation in which the remaining capacity of the battery (470) is below the configured threshold.

13. The method of claim 11, further comprising:
based on the threshold being configured as a first threshold and a second threshold according to the remaining capacity of the battery (470),
selecting at least one passive element configured based on the first threshold in response to the remaining capacity of the battery (470) being below the first threshold; and
selecting at least one passive element configured based on the second threshold in response to the remaining capacity of the battery (470) being below the second threshold.

14. The method of claim 11, further comprising:
based on a first passive element (611) and a second passive element (612) being selected together among the multiple passive elements, controlling the switch (610) such that the first passive element (611) and the second passive element (612) are electrically connected to the retaining member (460);
summing a first passive element value corresponding to the first passive element (611) and a second passive element value corresponding to the second passive element (612); and
applying the sum of passive element values to the retaining member (460).

15. A non-transitory computer-readable storage medium in which one or more programs for executing a method for connecting a passive element to an antenna of an electronic device are stored,
wherein the one or more programs, when executed by at least one processor (120), individually and/or collectively, of the electronic device, cause the electronic device to perform operations comprising:
identifying a remaining capacity of a battery disposed between a retaining member (460) comprising a support configured to function as an antenna corresponding to a first frequency band and a printed circuit board (480) comprising a communication circuit (190) electrically connected to the retaining member (460);
identifying information regarding a passive element (602) to be connected to the retaining member (460), based on the identified remaining capacity of the battery (470) and the first frequency band;
selecting at least one passive element among multiple passive elements, based on the identified information regarding a passive element (602); and
controlling a switch (610) such that the at least one selected passive element and the retaining member (460) are electrically connected.
